# EUROPÄISCHE PATENTSCHRIFT

(11) **EP 1 151 039 B1**
(45) Veröffentlichungstag und Bekanntmachung des Hinweises auf die Patenterteilung: **02.10.2002**
(21) Anmeldenummer: 00910646.9
(22) Anmeldetag: 07.02.2000
(51) Int. Cl.: C08L 61/06, C08L 79/00

(54) **NOVOLAK-CYANAT-BLENDS**
NOVOLAK CYANATE BLENDS
MELANGES NOVOLAQUES-CYANATES

(30) Priorität: 10.02.1999 EP 99102521; 21.06.1999 US 139798 P
(43) Veröffentlichungstag der Anmeldung: 07.11.2001
(73) Patentinhaber: Lonza AG, 4052 Basel (CH)
(72) Erfinder: DAUM, Ulrich, CH-4114 Hofstetten (CH); FALCHETTO, Alessandro, I-28845 Domodossola (IT)
(86) Internationale Anmeldenummer: EP0000944
(87) Internationale Veröffentlichungsnummer: WO00047676

(56) Entgegenhaltungen:
- US-A- 5 126 412
- US-A- 5 130 385
- US-A- 5 741 879
- US-A- 5 955 543

## Beschreibung

Die Erfindung betrifft Blends von Novolaken mit Cyanaten sowie ein Verfahren zu deren Herstellung.

Novolake (Phenol-Formaldehyd-Polykondensationsprodukte) können in der Regel thermisch, und zwar sowohl mit als auch ohne Katalysator, gehärtet werden. Um die Formstabilität der gehärteten Bauteile zu gewährleisten, müssen diese in der Regel einer Nachhärtung, d.h. einem sogenannten "post cure treatment", unterzogen werden. Damit die Teile sich hierbei nicht verziehen, werden sie in geeignete Formen eingespannt, was einen zusätzlichen Fertigungsaufwand bedeutet.

Die Aufgabe der Erfindung bestand darin, Novolak-Blends herzustellen, die diesen Nachteil nicht aufweisen, sondern schon nach kurzer thermischer Aushärtung so formstabil sind, dass sie freistehend getempert werden können.

Die Aufgabe konnte mit den erfindungsgemässen Blends von Novolaken mit Cyanaten nach Patentanspruch 1 gelöst werden.

Die Blends sind zusammengesetzt aus einem Novolak der allgemeinen Formel 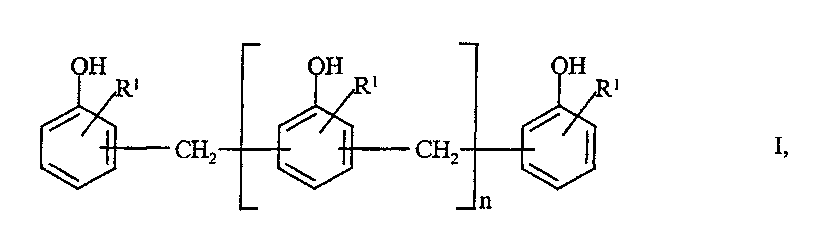 worin R¹ jeweils Wasserstoff oder Methyl ist und n eine Zahl grösser oder gleich 1 bedeutet, und einem Cyanat der allgemeinen Formel 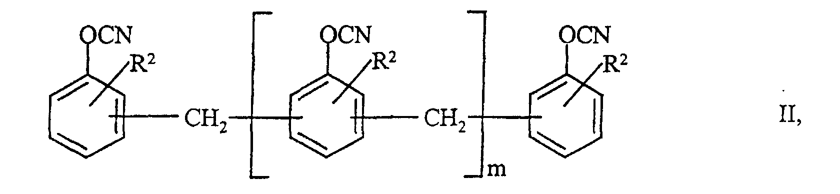 worin R² Methyl ist und m eine Zahl grösser oder gleich 1 bedeutet, sowie gegebenenfalls einem oder mehreren weiteren Polymer(en), Katalysator(en) und/oder üblichen Füll- oder Hilfsstoff(en).

Novolake der allgemeinen Formel I, insbesondere solche mit R' = H, sind bekannte und grosstechnisch in unterschiedlichen Qualitäten und Eigenschaften erhältliche oligomere Kondensationsprodukte von Phenolen mit Formaldehyd. Sie können mit oder ohne Zusatzstoffe polymerisiert werden. Geeignete Novolake mit R¹ = Methyl ("Kresol-Novolake") sind beispielsweise bei der Firma Borden Chemicals unter der Bezeichnung 371B erhältlich.

Cyanate der allgemeinen Formel II werden in der Regel durch Umsetzung der entsprechenden oligomeren Phenole mit Chlorcyan in Gegenwart eines tertiären Amins im technischen Massstab hergestellt und sind ebenfalls in verschiedenen Qualitäten und Eigenschaften verfügbar. Auch sie können mit oder ohne Zusatzstoffe polymerisiert werden. Als Katalysatoren können gegebenenfalls die für die Verarbeitung von Novolaken üblichen Verbindungen eingesetzt werden. Diese sind dem Fachmann bekannt. Als Füll- und Hilfsstoffe können beispielsweise flammhemmende Mittel oder Mittel zur Verbesserung der Wärmeleitfähigkeit oder der mechanischen oder elektrischen Eigenschaften des ausgehärteten Harzes zugefügt werden. Auch diese Mittel sind dem Fachmann bekannt.

Im erfindungsgemässen Blend ist der Anteil des Cyanats (II) an der Gesamtmenge von Cyanat (II) und Novolak (I) vorzugsweise von 10 Gew.% bis 90 Gew.%, der Anteil des Novolaks (I) vorzugsweise zwischen 90 Gew.% und 10 Gew.%, entsprechend einem Gewichtsverhältnis Cyanat:Novolak von 10:90 bis 90:10.

Bei der Herstellung der erfindungsgemässen Blends wird in der Regel so vorgegangen, dass die Komponenten physikalisch gemischt werden. Das Mischen kann beispielsweise in einer geeigneten Mühle, z. B. in einer Schwingmühle, erfolgen; die Komponenten können aber auch zusammen aufgeschmolzen oder mit Hilfe eines geeigneten Lösungsmittels vereinigt werden, wobei in letzterem Fall das Lösungsmittel wieder entfernt werden muss.

Die erfindungsgemässen Blends sind in kurzer Zeit thermisch härtbar, ausserdem zeichnen sie sich aus durch eine hohe Langzeitstabilität in ungehärtetem Zustand, wie z. B. aus der konstanten Gelierzeit ersichtlich ist.
Ein weiterer Vorteil der erfindungsgemässen Blends liegt darin, dass die Gelierzeit und damit der Härtezyklus für den Blend erheblich kürzer ist als für die einzelnen Komponenten des Blends. Der Einsatz von Katalysatoren wird dadurch entweder ganz überflüssig oder lässt sich zumindest erheblich vermindern.

Gegenstand der Erfindung ist im weiteren das Harz, welches durch thermische Härtung des Blends gemäss Patentanspruch 1 erhältlich ist.

Die Härtung der Mischung erfolgt vorteilhaft ohne Katalysator durch Erwärmung der Mischung auf eine Temperatur von 100 °C bis 300 °C, vorzugsweise 150 °C bis 250 °C, während einer Dauer von 1 Minute bis 15 Minuten.

Die so erhaltenen gehärteten Blends zeichnen sich durch eine hervorragende Formstabilität aus und sind damit z. B. in Bindemitteln für Schleifmittel oder im Elektronikbereich für Chipumhüllungen oder Leiterplatten (PCB) einsetzbar.

Die folgenden Beispiele verdeutlichen die Herstellung und Eigenschaften der erfindungsgemässen Blends, ohne dass darin eine Einschränkung zu sehen ist.

### Beispiele

Es wurden folgende Novolake der Formel I eingesetzt:
Novolak A R¹ = Methyl
Novolak B R¹ = H, niedriges Molekulargewicht
Novolak C R¹ = H, hohes Molekulargewicht

Die aufgeführten Novolake wurden bei der jeweils angegebenen Lagertemperatur mit dem Cyanat (II) gemischt.

Zur Messung der Gelierzeit wurden jeweils 5 g einer frisch hergestellten bzw. für die angegebene Zeitdauer gelagerten Probe der Mischung auf eine auf 200 °C erwärmte Platte von 10 × 10 cm gegeben und die Zeit gemessen, bis die Gelierung einsetzte (Gelierzeit). Die Ergebnisse der Messungen sind in der folgenden Tabelle 1 zusammengefasst. Felder ohne Eintrag bedeuten, dass nach der entsprechenden Zeit keine Messung durchgeführt wurde.

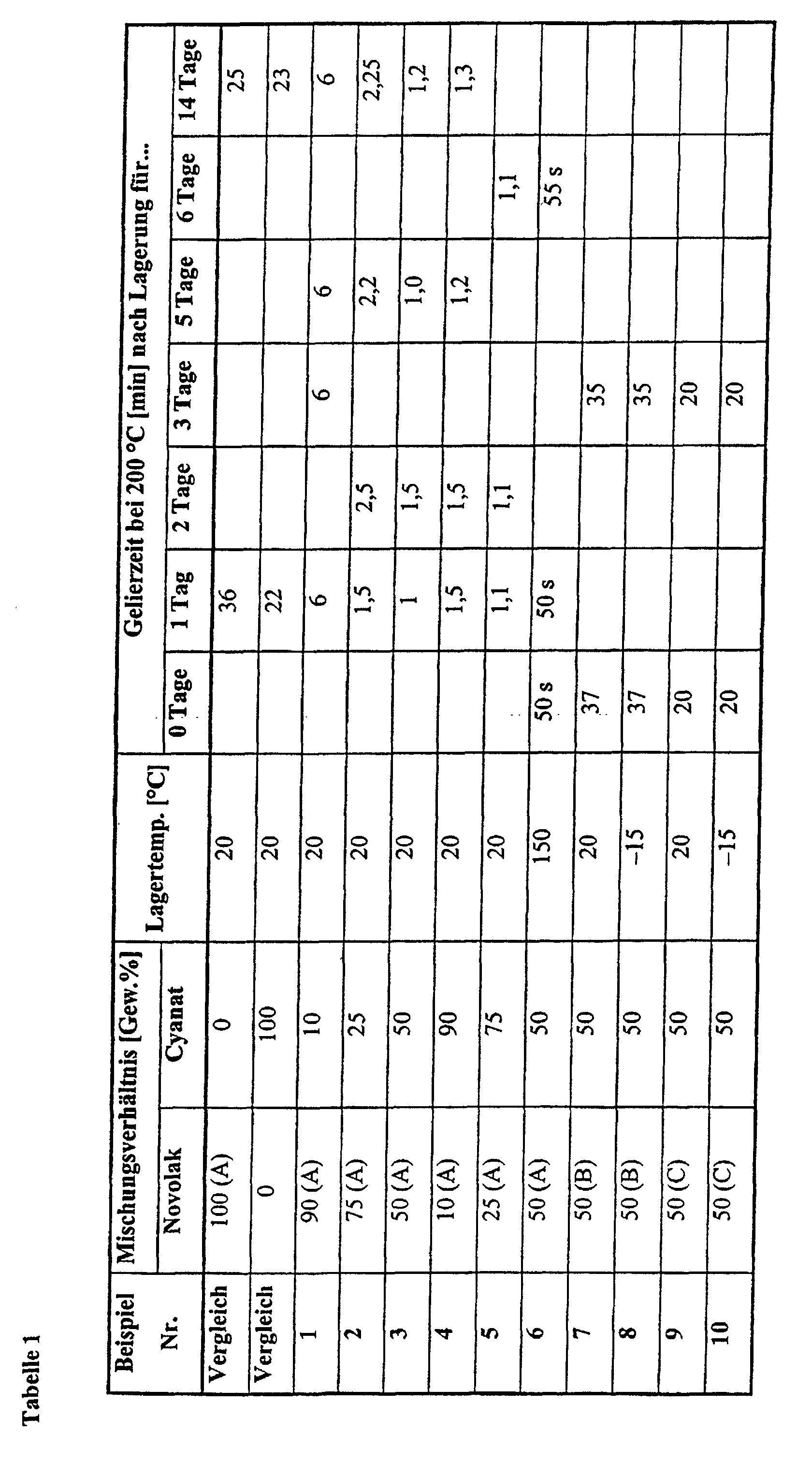

## Patentansprüche

1. Blends von Novolaken mit Cyanaten, zusammengesetzt aus einem Novolak der allgemeinen Formel 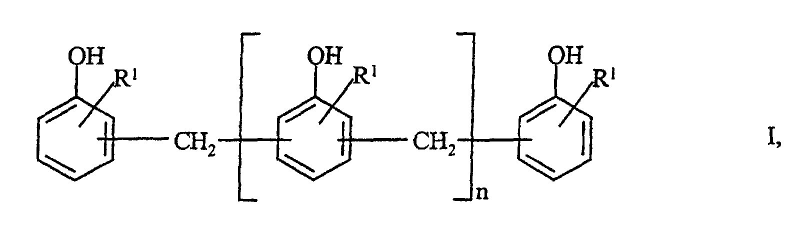 worin R¹ jeweils Wasserstoff oder Methyl ist und n eine Zahl ≥1 bedeutet, und einem Cyanat der allgemeinen Formel 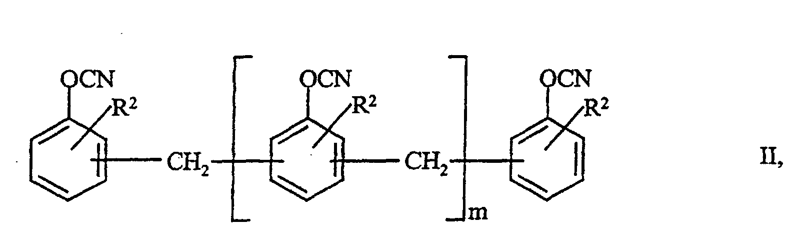 worin R² Methyl ist und m eine Zahl ≥1 bedeutet, und gegebenenfalls weiteren Polymeren, Katalysatoren und/oder Füll- oder Hilfsstoffen.

2. Blend nach Anspruch 1, **dadurch gekennzeichnet, dass** das Gewichtsverhältnis von Cyanat (II) und Novolak (I) 10:90 bis 90:10 beträgt.

3. Harz, erhältlich durch thermische Härtung eines Blends gemäss Anspruch 1 oder 2.

4. Verfahren zur Herstellung von einem Harz gemäss Patentanspruch 3, **dadurch gekennzeichnet, dass** ein Blend gemäss Anspruch 1 oder 2 einer Härtung bei einer Temperatur zwischen 100 °C und 300 °C unterzogen wird.

## Claims

1. Blends of novolaks and cyanates, composed of a novolak of the general formula 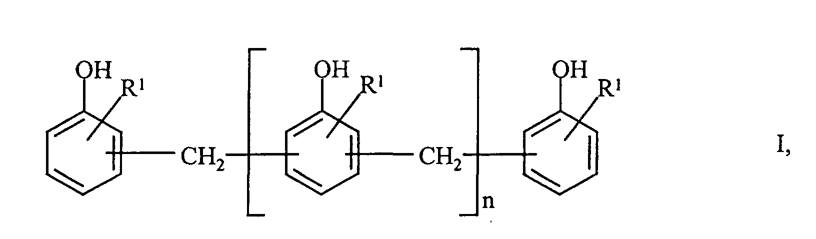 wherein R¹ is hydrogen or methyl and n is a number ≥1 and a cyanate of the general formula 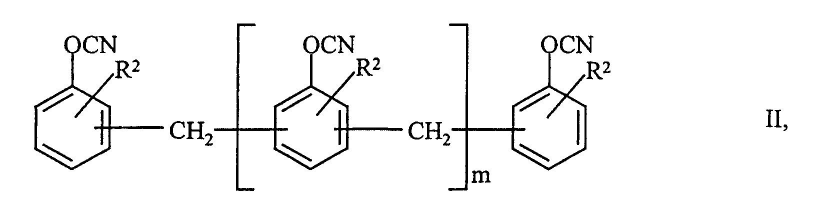 wherein R² is methyl and m is a number ≥1, and, optionally, further polymers, catalysts and/or fillers or auxiliaries.

2. Blend according to Claim 1, **characterized in that** the weight ratio of cyanate (II) and novolak (I) is 10:90 to 90:10.

3. Resin obtainable by thermal curing of a blend according to either of Claims 1 and 2.

4. Process for preparing a resin according to Claim 3, **characterized in that** a blend according to either of Claims 1 and 2 is subjected to curing at a temperature of 100 to 300 °C.

## Revendications

1. Mélanges de novolaques avec des cyanates, constitués d'une novolaque de formule générale 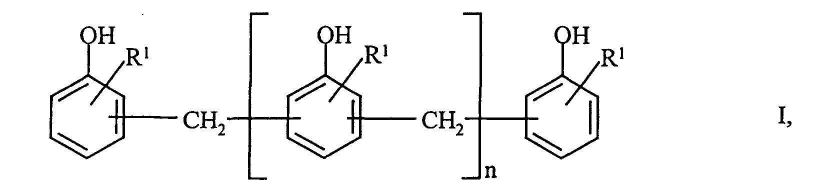 dans laquelle R¹ représente à chaque fois un hydrogène ou un méthyle et n signifie un nombre ≥1 et d'un cyanate de formule générale 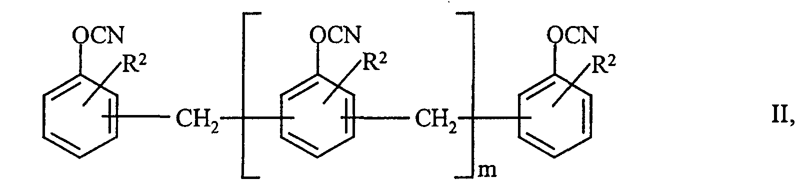 dans laquelle R² représente un méthyle et m signifie un nombre ≥1 ainsi que le cas échéant d'autres polymères, catalyseurs et/ou charges ou adjuvants.

2. Mélange selon la revendication 1, **caractérisé en ce que** le rapport pondéral cyanate (II) à novolaque (I) est de 10:90 à 90:10.

3. Résine pouvant être obtenue par durcissement thermique d'un mélange selon la revendication 1 ou 2.

4. Procédé pour la préparation d'une résine selon la revendication 3, **caractérisé en ce qu'**un mélange selon la revendication 1 ou 2 est soumis à un durcissement à une température entre 100 °C et 300 °C.
